Europäisches Patentamt

European Patent Office

Office européen des brevets

(11) Veröffentlichungsnummer: **0 173 275 B1**

(12) # EUROPÄISCHE PATENTSCHRIFT

(45) Veröffentlichungstag der Patentschrift: 06.03.91    (51) Int. Cl.⁵: **H01L 31/111**

(21) Anmeldenummer: 85110674.0

(22) Anmeldetag: 24.08.85

(54) **Lichtzündbarer Thyristor.**

(30) Priorität: 30.08.84 DE 3431817

(43) Veröffentlichungstag der Anmeldung:
05.03.86 Patentblatt 86/10

(45) Bekanntmachung des Hinweises auf die
Patenterteilung:
06.03.91 Patentblatt 91/10

(84) Benannte Vertragsstaaten:
CH FR GB IT LI

(56) Entgegenhaltungen:
EP-A- 0 021 086
EP-A- 0 064 718
EP-A- 0 098 997
DE-A- 2 107 564
DE-A- 3 102 851

(73) Patentinhaber: SEMIKRON Elektronik GmbH
Sigmundstrasse 200
W-8500 Nürnberg 82(DE)

(72) Erfinder: Tursky, Werner, Dipl.-Ing. Dr.
Motterstrasse 42
W-8500 NÜrnberg(DE)
Erfinder: Grube, Reinhard, Dipl.-Phys. Dr. rer.
nat.
Abtsteinacherstrasse 70
W-6943 Birkenau 5(DE)

EP 0 173 275 B1

## Beschreibung

Die Erfindung betrifft einen lichtzündbaren Thyristor mit einem Halbleiterkörper, der aus einer Folge von wenigstens vier schichtförmigen Zonen abwechselnd entgegengesetzten Leitungstyps besteht, an jeder der beiden Außenzonen mit einer Laststromelektrode, an der mit der einen Außenzone als Hauptemitter eine gemeinsame Oberfläche bildenden Basiszone mit einem lichtzündbaren Bereich als Hilfsemitter und an dem Hauptemitter mit Emitterkurzschlüssen versehen ist, und welcher Mittel zur Entkopplung der optischen Zündempfindlichkeit von der Zündempfindlichkeit durch Störströme aufweist.

Lichtzündbare Thyristoren erfordern wegen der im allgemeinen höheren Zündempfindlichkeit gegenüber solchen mit Ladungsträgerinjektion mittels Steuerstromzündung und insbesondere im Falle der Auslegung für eine Zündempfindlichkeit bei niedriger Anregungsdichte einen erhöhten Schutz gegen Zündvorgänge oder Störströme, die durch unzulässige Spannungsanstiegsgeschwindigkeit oder durch Ansteigen der Betriebstemperaturen entstehen können. Das heißt, es sind Maßnahmen not wendig, welche die Störzündempfindlichkeit unabhängig von der optischen Zündempfindlichkeit verringern oder möglichst beseitigen.

Aus der DE-OS 25 49 563 sind lichtzündbare Thyristoren bekannt bei welchen die gewünschte Störsicherheit gegen Durchzünden dadurch erreicht werden soll, daß ein sogenanntes Störpotential, das durch Störströme in der Steuerbasiszone unter dem lichtzündbaren Emitter entsteht, durch eine Potentialerhöhung im Randbereich der Steuerbasiszone mittels einer ohmischen Verbindung zwischen Emitter- und Randbereich kompensiert wird.

Zur Verbesserung der Störsicherheit bei solchen Anordnungen ist es weiter aus der DE-PS 27 39 187 bekannt, zusätzlich zu der ohmischen Verbindung, zwischen dem Zündbereich der Emitterzone und der Kathode ein eine nicht lineare Charakteristik aufweisendes Bauelement, vorzugsweise eine Halbleiterdiode, anzuordnen.

Schließlich sind in der DE-OS 29 45 335 lichtzündbare Thyristoren beschrieben, die an der Emitterschicht innerhalb eines lateralen, lichtzündbaren Bereichs gate-gesteuerte MIS-Strukturen aufweisen, welche steuerbare Emitter-Kurzschlußpfade enthalten. Die Funktion derselben ist beim Bestrahlen der Emitterzone aufgehoben.

Der Erfindung liegt die Aufgabe zugrunde, eine Struktur eines lichtzündbaren Thyristors anzugeben, bei welcher die Entkoppelung der optischen Zündempfindlichkeit von der Störzünd empfindlichkeit gegenüber bekannten Bauformen auf andere, technologisch einfachere Weise erreicht wird und optimiert ist.

Die Lösung der Aufgabe besteht bei einem Thyristor der eingangs erwähnten Art in den Merkmalen des Anspruchs 1.

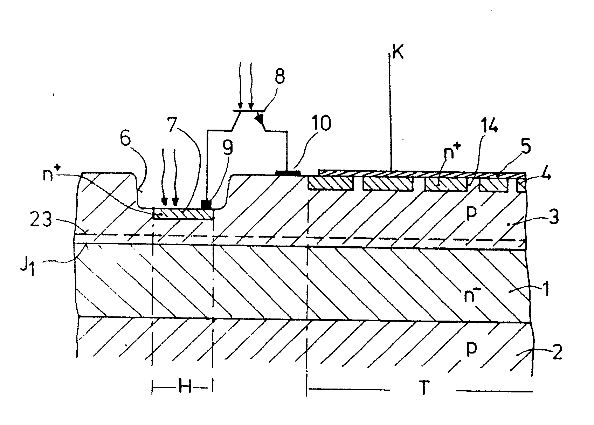

Vorteilhafte Weiterbildungen sind in den Unteransprüchen 2 bis 8 angegeben. Anhand des Ausführungsbeispiels in der Figur wird die Erfindung näher erläutert. Der im Querschnitt dargestellte Ausschnitt des Halbleiterkörpers zeigt eine Schichtenfolge mit einer hochohmigen, n-leitenden Mittelzone 1 und je einer, auf jeder Seite der Mittelzone angrenzenden, höherdotierten, p-leitenden Zone 2, 3. In die als Steuerbasiszone bezeichnete Zone 3 ist als die eine Außenzone die hochdotierte, n-leitende Emitterzone 4 als Hauptemitter eingelassen angeordnet. Steuerbasiszone 3 und Hauptemitter 4 bilden somit eine gemeinsame Oberfläche. Die andere Außenzone, nämlich die Zone 2, ist nur teilweise dargestellt. Die Emitterzone 4 weist zum Durchgriff der Steuerbasiszone 3 Durchbrüche 14 auf, die durch entsprechende Kontaktierung der Kathodenelektrode 5 Emitterkurzschlüsse bilden. In einem z.B. zentral angeordneten Abschnitt der Oberfläche der Steuerbasiszone 3 ist eine Vertiefung 6 angebracht, an deren Bodenfläche ein hochdotierter, n-leitender, lichtzündbarer Emitterbereich 7 als Hilfsemitter des Hilfsthyristors H ausgebildet ist, der die Funktion der Steuerzone erfüllt. Eine solche Struktur ist allgemein zur Verbesserung der Zündempfindlichkeit von Thyristoren bekannt.

Erfindungsgemäß ist nun zwischen lichtzündbarem Emitterbereich 7 und Emitterzone 4, d.h., zwischen Hilfsemitter 7 und Hauptemitter 4 des Thyristors T, möglichst nahe an dem letzteren, eine ohmische Verbindung mit einem Schalter 8 angeordnet, durch welchen ein Strompfad mit niedrigem ohmischen Widerstand für den durch Lichteinstrahlung zu bewirkenden Zündvorgang gebildet ist. Generell sind Schalter unterschiedlichen Prinzips verwendbar. Jedoch ist ein Schließen des Schalters 8 synchron mit dem Beginn der Lichteinwirkung bzw. mit dem Durchzünden des dem Hilfsemitter 7 zugeordneten Volumenabschnitts der Thyristorstruktur vorteilhaft, und daher ist Halbleiterschaltern aufgrund ihrer kurzen Schaltzeiten der Vorzug zu geben. Mit Phototransistoren wurden günstige Ergebnisse erzielt. Dabei ist der Kollektor des Phototransistors 8 über den ohmischen Kontakt 9 mit dem Hilfsemitter 7 und der Emitter des Phototransistors über den ohmischen Kontakt 10 mit der Steuerbasiszone 3 verbunden.

Der Abstand zwischen Hilfsemitter 7 und Hauptemitter 4 ist so bemessen, daß der dadurch bestimmte Strompfad innerhalb der Steuerbasiszone 3 beim Zünden durch Bestrahlen einen höheren Widerstand aufweist als der Strompfad über den Schalter 8. Vorteilhafte Ergebnisse wurden mit Strukturen erzielt, bei denen der Abstand 2 bis 4 mm beträgt.

Die Verwendung eines Phototransistors hat zusätzlich noch den Vorteil des Verstärkereffekts für den Zündstrom zum Hauptemitter 4.

Zum Betrahlen des Hilfsemitters 7 und des Schalters 8 können lichtemittierende Halbleiterbauelemente vorgesehen sein. Für gleichzeitige Lichteinwirkung sind zum Beispiel lichtemittierende Dioden in Reihe geschaltet.

Gemäß der Darstellung in der Figur ist der Hilfsemitter 7 in einer Vertiefung 6 der Steuerbasiszone 3 angebracht. Dem liegt die Erkenntnis zugrunde, daß niedriger dotierte Siliziumschichten für Licht des in Betracht kommenden Wellenlängenbereiches besser durchlässig sind als höherdotierte Schichten. Das versenkte Anordnen des lichtzündbaren Bereichs ermöglicht bei lichtzündbaren Thyristoren besonders vorteilhaft eine Auslegung für niedrige Anregungsdichte. Ist bei dieser Struktur nach der Erfindung der Schalter 8 geschlossen, so wird der lichtaktive Bereich 7, d.h. der Hilfsemitter, mit dem Potential der freien Halbleiteroberfläche in unmittelbarer Nähe der Kathode, somit praktisch mit dem Kathodenpotential beaufschlagt. Dadurch liegt an der kurzen Strecke zwischen Hilfsemitter 7 und pn-Übergang $J_1$ die gleiche Potentialdifferenz wie zwischen Hauptemitter 4 und pn-Übergang $J_1$.

Die Tiefe der Anordnung des Hilfsemitters 7 ist aber auch durch die Forderung nach Gewährleistung der vorgesehenen Blockierspannung bestimmt. Nachdem die Raumladungszone, über welcher die Blockierspannung abfällt, sich in der Steuerbasiszone 3 aus physikalischen Gründen nur als schmaler Streifen ausbildet (Vergleiche unterbrochene Linie 23), kann der Hilfsemitter 7 sehr tief eingelassen sein. Infolge der sehr kurzen Wegstrecke der Photonen zur Raumladungszone ist damit die optische Zündempfindlichkeit optimiert und die Flächenausdehnung des Hilfsemitters 7 auf sehr kleine Werte reduzierbar. Eine Fläche in der Größenordnung von 1 mm$^2$ hat sich als ausreichend erwiesen.

Mit einer solchen Ausgestaltung ist auch der Forderung nach möglichst geringem Störpotential im Bereich des Hilfsemitters 7 bei Auftreten von Störströmen Rechnung getragen.

Das Halbleiterschaltelement kann auch monolitisch integriert im Halbleiterkörper angeordnet sein.

Die Struktur nach der Erfindung zeigt eine perfekte Entkopplung der optischen Zündempfindlichkeit von der Störzündempfindlichkeit. Bei Ansteuerung durch lichtemittierende Bauelemente zündet zunächst der Hilfsthyristor H. Über den gleichzeitig mit dem Einleiten des Zündvorgangs geschlossenen Schalter 8, d.h., über den niederohmigen Strompfad der Optokopplung mit durchgeschaltetem Phototransistor, fließen Ladungsträger zum Hauptemitter 4, welcher dadurch zur Emission angeregt wird.

Ohne Lichteinwirkung ist der Phototransistor gesperrt. Störströme, z.B. aufgrund unzulässig steller Spannungsanstiegsgeschwindigkeit, fließen aus der Steuerbasiszone 3 zwangsläufig über die Emitterkurzschlüsse 14 zur Kathode K ab.

## Ansprüche

1. Lichtzündbarer Thyristor mit einem Halbleiterkörper, der
   - aus einer Folge von wenigstens vier schichtförmigen Zonen (1,2,3,4) abwechselnd entgegengesetzten Leitungstyps besteht,
   - an jeder der beiden Außenzonen (2,4) mit einer Laststromelektrodeversehenist,
   - an der mit der einen Außenzone als Hauptemitter (4) eine gemeinsame Oberfläche bildenden Basiszone (3) mit einem lichtzündbaren Bereich als Hilfsemitter (7) und
   - an dem Hauptemitter mit Emitterkurzschlüssen versehen ist, und
   - welcher Mittel zur Entkopplung der optischen Zündempfindlichkeit von der Zündempfindlichkeit durch Störströme aufweist,
   **dadurch gekennzeichnet**, daß
   
   - als Mittel zur Entkopplung ein Schalter (8) in einer Verbindung des Hilfsemitters (7) mit der Basiszone (3) nahe dem Hauptemitter (4) vorgesehen ist, und daß dieser Schalter bei Ansteuerung des Thyristors durch licht schließt.

2. Thyristor nach Anspruch 1, dadurch gekennzeichnet, daß als Schalter (8) ein Halbleiterschaltelement vorgesehen ist.

3. Thyristor nach Anspruch 2, dadurch gekennzeichnet, daß als Halbleiterschaltelement ein Phototransistor vorgesehen ist.

4. Thyristor nach Anspruch 2, dadurch gekennzeichnet, daß das Halbleiterschaltelement monolitisch integriert angeordnet ist.

5. Thyristor nach Anspruch 1 oder einem der folgenden Ansprüche, dadurch gekennzeichnet, daß der Abstand zwischen Hilfsemitter (7) und Hauptemitter (4) maximal 4 mm beträgt.

6. Thyristor nach Anspruch 1, dadurch gekennzeichnet, daß der Hilfsemitter (7) in einer Vertiefung (6) der Steuerbasiszone (3) angeordnet ist, die sich bis nahe an die Raumladungszone erstreckt.

7. Thyristor nach Anspruch 3 dadurch gekennzeichnet, daß zur Ansteuerung des Hilfsemitters (7) und des Phototransistors (8) lichtemittierende Halbleiterbauelemente vorgesehen sind.

8. Thyristor nach Anspruch 7, dadurch gekennzeichnet, daß als lichtemittierende Halbleiterbauelemente lichtemittierende Dioden vorgesehen und zur gleichzeitigen Ansteuerung des Hilfsemitters und des Phototransistors in Reihe geschaltet sind.


## Claims

1. Optically triggerable thyristor with a semiconductor body which
   - consists of a series of at least four layer-shaped zones (1, 2, 3, 4) of alternating, complementary conduction type,
   - is provided with a load current electrode on each of the two outside zones (2, 4),
   - is provided with an optically triggerable area on the base zone (3), which forms a common surface with one of the outside zones that functions as the main emitter (4), said optically triggerable area functioning as an auxiliary emitter (7), and
   - is provided with emitter short-circuit paths on the main emitter, said thyristor embodying means for decoupling the sensitivity to optical triggering from the sensitivity to being triggered by disturbing currents, characterized in that, as a decoupling means, a switch (8) is provided near the main emitter (4), in a connection between the auxiliary emitter (7) and the base zone (3), and in that this switch closes when the thyristor is activated by light.

2. Thyristor according to Claim 1, characterized in that a semiconductor switching device is provided as the switch (8).

3. Thyristor according to Claim 2, characterized in that a phototransistor is provided as the semiconductor switching device.

4. Thyristor according to Claim 2, characterized in that the semiconductor switching device is provided in a manner such that it is monolithically integrated.

5. Thyristor according to Claim 1 or any one of the following Claims, characterized in that the distance between the auxiliary emitter (7) and the main emitter (4) does not exceed 4 mm.

6. Thyristor according to Claim 1, characterized in that the auxiliary emitter (7) is provided inside a recess (6) in the gate base zone (3), extending to within a short distance of the space charge region.

7. Thyristor according to Claim 3, characterized in that light-emitting semiconductor devices are provided for activating the auxiliary emitter (7) and the phototransistor (8).

8. Thyristor according to Claim 7, characterized in that light-emitting diodes are provided as light-emitting semiconductor devices, and are series-connected so as to ensure simultaneous activation of the auxiliary emitter and phototransistor.


## Revendications

1. Thyristor déclenché par de la lumière avec un corps semi-conducteur
   - qui se compose d'au moins quatre zones en forme de couches successives (1), (2), (3), (4) alternativement de type opposé,
   - dont chaque couche extérieure (2), (4) comporte une électrode de courant de charge,
   - dont la couche de base (3) forme avec l'une des couches extérieures constituant l'émetteur principal (4) une surface unique et comporte une zone déclenchée par de la lumière constituant un émetteur auxiliaire (7),
   - dont l'émetteur principal comporte des émetteurs court-circuités,
   - qui est pourvu de moyens pour découpler la puissance d'amorçage optique de la puissance d'amorçage par des courants parasites, *caractérisé en ce que* le moyen de découplement est constitué d'un interrupteur (8) qui est disposé près de l'émetteur principal (4), dans une connexion entre la couche de base (3) et l'émetteur auxiliaire (7), et qui se ferme lorsque le thyristor est déclenché par de la lumière.

2. Thyristor selon la revendication 1 *caractérisé en ce que* l'interrupteur (8) est un élément de circuit semi-conducteur.

3. Thyristor selon la revendication 2 *caractérisé en ce que* l'élément de circuit semi-conducteur est un phototransistor.

4. Thyristor selon la revendication 2 *caractérisé en ce que* l'élément de circuit semi-conducteur est intégré monolithiquement dans le circuit.

5. Thyristor selon l'une des revendications 1 à 4 *caractérisé en ce que* la distance entre l'émetteur principal (4) et l'émetteur auxiliaire (7) est au maximum de 4 mm.

6. Thyristor selon la revendication 1 *caractérisé en ce que* l'émetteur auxiliaire (7) est disposé dans un évidement (6) dans la couche de base de commande (3), qui s'étend près de la zone de charge d'espace.

7. Thyristor selon la revendication 3 *caractérisé en ce que* le déclenchement de l'émetteur auxiliaire (7) et du phototransistor (8) est assuré par des éléments semi-conducteurs électroluminescents.

8. Thyristor selon la revendication 7 *caractérisé en ce que* les éléments semi-conducteurs électroluminescents sont des diodes électroluminescentes montées en série en vue de déclencher simultanément l'émetteur auxiliaire et le phototransistor.